(19) Europäisches Patentamt
European Patent Office
Office européen des brevets

(11) **EP 4 027 119 A1**

(12) **EUROPEAN PATENT APPLICATION**
published in accordance with Art. 153(4) EPC

(43) Date of publication:
**13.07.2022 Bulletin 2022/28**

(21) Application number: **20861869.4**

(22) Date of filing: **03.09.2020**

(51) International Patent Classification (IPC):
***G01H 9/00*** (2006.01)

(52) Cooperative Patent Classification (CPC):
**G01H 9/00**

(86) International application number:
**PCT/JP2020/033353**

(87) International publication number:
**WO 2021/045135 (11.03.2021 Gazette 2021/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.09.2019 JP 2019160471**

(71) Applicant: **Shinkawa Ltd.**
**Tokyo 208-8585 (JP)**

(72) Inventors:
• **KIRKBY, Michael**
  **Musashimurayama-shi, Tokyo 208-8585 (JP)**
• **NAKANO, Shota**
  **Musashimurayama-shi, Tokyo 208-8585 (JP)**
• **MUNAKATA, Hiroshi**
  **Musashimurayama-shi, Tokyo 208-8585 (JP)**

(74) Representative: **Dennemeyer & Associates S.A.**
**Postfach 70 04 25**
**81304 München (DE)**

(54) **VIBRATION DETECTION SYSTEM**

(57) A vibration detection system (100) that detects vibrations of an ultrasonic horn (12) and a capillary (13) having a non-mirror surface includes a laser light source (20) that irradiates the ultrasonic horn (12) and the capillary (13) with parallel laser light (21), a camera (30) that includes an imaging device (31) that captures an image of the ultrasonic horn (12) and the capillary (13) irradiated with the parallel laser light (21), and an image processing apparatus (40) that processes the image captured by the camera (30) and that displays a vibrating potion.

FIG. 1

EP 4 027 119 A1

**Description**

Technical Field

The present invention relates to a vibration detection system that detects a vibration of an observation target, and more particularly, to a vibration detection system that detects a vibration of an observation target having a non-mirror surface.

Background Art

In a wire bonding apparatus, in order to observe an ultrasonic vibration of a tool such as a capillary, a method using a laser Doppler vibrometer is often used (see, for example, Patent Literature 1).

Citation List

Patent Literature

Patent Literature 1: JP 2013-125875 A

Summary of Invention

Technical Problem

In recent years, there has been a demand for a real-time detection of a vibration on a two-dimensional surface of an observation target. However, in the method described in Patent Literature 1, the location where a vibration is measured is limited to a point or a line irradiated with laser light, and it has been impossible to detect a vibration on a two-dimensional surface in real time.

Therefore, an object of the present invention is to detect a vibration on a two-dimensional surface of an observation target in real time.

Solution to Problem

A vibration detection system according to the present invention is a vibration detection system that detects a vibration of an observation target having a non-mirror surface, the vibration detection system including: a laser light source that irradiates the observation target with laser light; a camera that includes an imaging device that captures and acquires an image of the observation target irradiated with the laser light; and an image processing apparatus that processes the image captured by the camera and that displays a vibrating potion.

In this manner, because the vibrating potion is identified based on the two-dimensional image captured by the camera, it is possible to detect a vibration on the two-dimensional surface of the observation target in real time.

In the vibration detection system according to the present invention, the camera may use an exposure time longer than a vibration cycle of the observation target at the time of imaging, and acquire the image as an image including an interference pattern that is formed by interference of reflections of the laser light from the surface of the observation target, and the image processing apparatus may identify a vibrating pixel based on a deviation between an image including an interference pattern of the observation target during a non-vibrating period and an image including an interference pattern of the observation target during a vibrating period, the images being those acquired by the camera, and output an observation image that is an image of the observation target including an indication corresponding to the identified vibrating pixel.

When an observation target having a non-mirror surface is irradiated with laser light, an interference pattern resultant of interference of non-specular reflections of the laser light appears on the surface of the imaging device of the camera. The imaging device of the camera acquires an image of the interference pattern. Because the exposure time of the camera at the time of imaging is longer than the vibration cycle of the observation target, when the observation target vibrates, the image acquired by the camera includes a blurred interference pattern. When the image of the interference pattern is blurred, the luminous intensities of the pixels change from those with no vibration. Therefore, a pixel where the luminous intensity changes during the period of vibration from that of a period without vibration is identified as a vibrating pixel, and an observation image that is an image of the observation target including an indication corresponding to the identified vibrating pixel is output, so that the vibrating portion of the observation target can be visualized and displayed.

In the vibration detection system according to the present invention, when there are a predetermined number of other vibrating pixels within a predetermined range around the identified vibrating pixel, the image processing apparatus may maintain the pixel as a pixel identified as the vibrating pixel, and when there are no predetermined number of vibrating pixels within the predetermined range, the image processing apparatus may cancel the identification of the pixel as the vibrating pixel.

As a result, it is possible to suppress identifying a noise pixel that is not actually vibrating as a vibrating pixel, so that the vibration can be detected accurately.

In the vibration detection system according to the present invention, the laser light source may irradiate the observation target with parallel laser light having a single wavelength.

By irradiating the observation target with the parallel laser light having the single wavelength, the interference pattern of the laser light resultant of the non-specular reflections are captured more clearly, and the spotty pattern captured by the camera becomes clearer. In this manner, vibrations can be detected more accurately. Advantageous Effects of Invention

The present invention can detect a vibration on a two-dimensional surface of an observation target in real time.

Brief Description of Drawings

FIG. 1 is a system diagram illustrating a configuration of a vibration detection system according to an embodiment.

FIG. 2 is a schematic diagram illustrating a condition in which parallel laser light reflected on a capillary surface becomes incident on an imaging device of a camera.

FIG. 3 is a schematic diagram illustrating an image captured by the camera.

FIG. 4 is a schematic diagram illustrating pixels of the imaging device included in the camera.

FIG. 5 is a flowchart illustrating image processing performed in an image processing apparatus.

FIG. 6 is a schematic diagram illustrating an observation image output to a monitor.

Description of Embodiment

A vibration detection system 100 according to an embodiment will now be described with reference to the drawings. In the following description, it is assumed that the vibration detection system 100 uses an ultrasonic horn 12 and a capillary 13 of a wire bonding apparatus 10 as observation targets, and detects their vibrations.

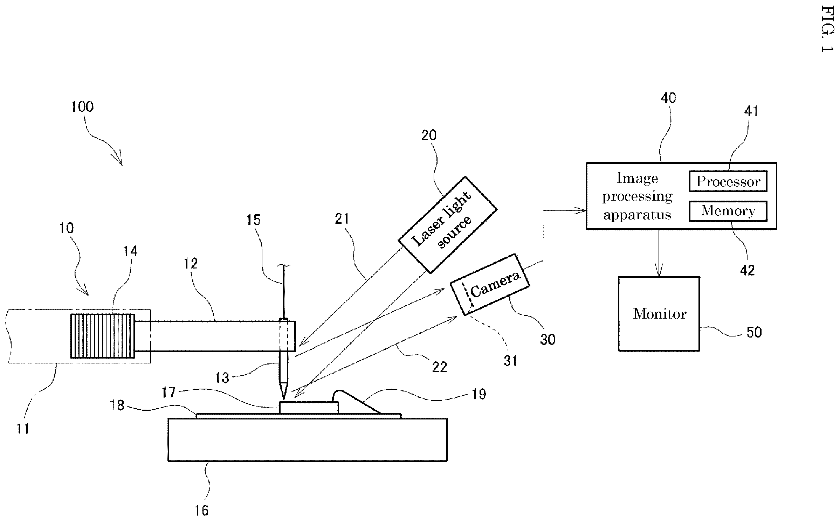

To begin with, the wire bonding apparatus 10 including the ultrasonic horn 12 and the capillary 13, which are observation targets, will be described briefly with reference to FIG. 1. The wire bonding apparatus 10 includes a bonding arm 11, the ultrasonic horn 12, the capillary 13, an ultrasonic transducer 14, and a bonding stage 16.

The capillary 13 is attached to the tip of the ultrasonic horn 12, and the ultrasonic transducer 14 is attached to the rear end. The ultrasonic horn 12 is caused to vibrate ultrasonically by ultrasonic vibrations generated by the ultrasonic transducer 14, and causes the capillary 13 to vibrate ultrasonically. The ultrasonic horn 12 is connected to the bonding arm 11, and is driven in a direction bringing the capillary 13 into contact with and away from the bonding stage 16 by a driving mechanism (not illustrated). The bonding stage 16 suctions and fixes a substrate 18 having a semiconductor device 17 attached to its surface. In the wire bonding apparatus 10, the driving mechanism (not illustrated) presses the tip of the capillary 13 against an electrode of the semiconductor device 17 to bond a wire 15 to the electrode of the semiconductor device 17, and moves the capillary 13 onto an electrode of a substrate 18 and presses the tip of the capillary 13 against the electrode of the substrate 18 to bond the wire 15 to the electrode of the substrate 18. In this manner, the wire bonding apparatus 10 connects the electrode of the semiconductor device 17 and the electrode of the substrate 18 with a loop wire 19. Therefore, during the bonding operation, the ultrasonic horn 12 and the capillary 13 vibrate ultrasonically. The vibration detection system 100 according to the embodiment detects and displays vibrations on a two-dimensional surface of the ultrasonic horn 12 or the capillary 13. The surfaces of the ultrasonic horn 12 and the capillary 13 are non-mirror surfaces and have small irregularities.

As illustrated in FIG. 1, the vibration detection system 100 includes a laser light source 20, a camera 30, and an image processing apparatus 40.

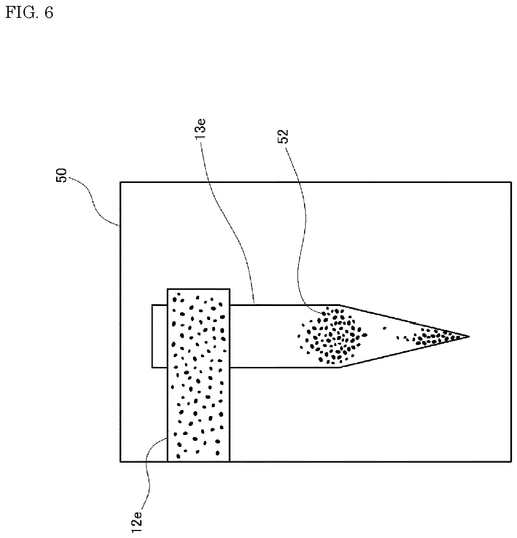

The laser light source 20 uses a beam expander to collimate single-wavelength laser light output from a laser oscillator into parallel laser light 21, and irradiates the ultrasonic horn 12 and the capillary 13 with the parallel laser light 21 at a single wavelength. The camera 30 includes an imaging device 31, and captures a two-dimensional image of the ultrasonic horn 12 or the capillary 13 irradiated with the parallel laser light 21. The image processing apparatus 40 processes the two-dimensional image captured by the camera 30 to identify vibrating potions, and outputs and displays two-dimensional observation images 12e and 13e (see FIG. 6) in which the vibration portions are displayed differently from the other portions, on a monitor 50. The image processing apparatus 40 is a computer internally including a processor 41 performing information processing and a memory 42.

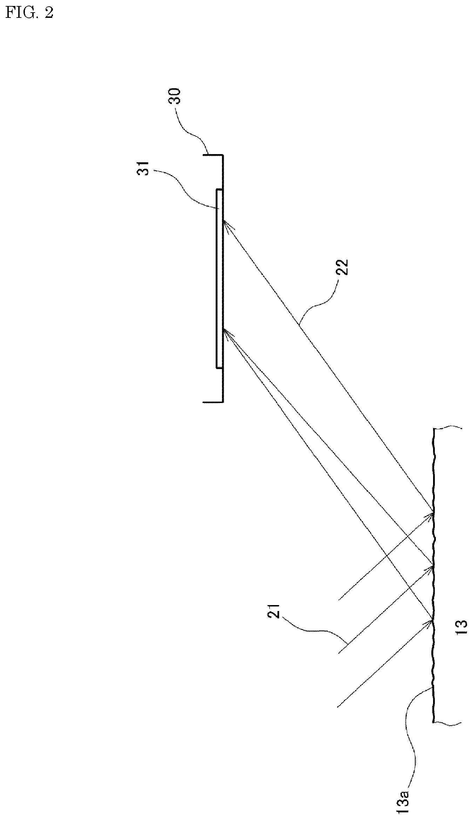

An operation of the vibration detection system 100 according to the embodiment will now be described with reference to FIGS. 2 to 6.

As illustrated in FIG. 2, because a surface 13a of the capillary 13 is a non-mirror surface, and the surface 13a has small irregularities, when the surface 13a of the capillary 13 is irradiated with the parallel laser light 21, the surface 13a of the capillary 13 reflects the parallel laser light 21 in random directions. The rays of the reflected laser light 22 due to the non-specular reflection cause interference with one another, and the reflected laser light 22 produces an interference pattern on the surface of the imaging device 31 of the camera 30.

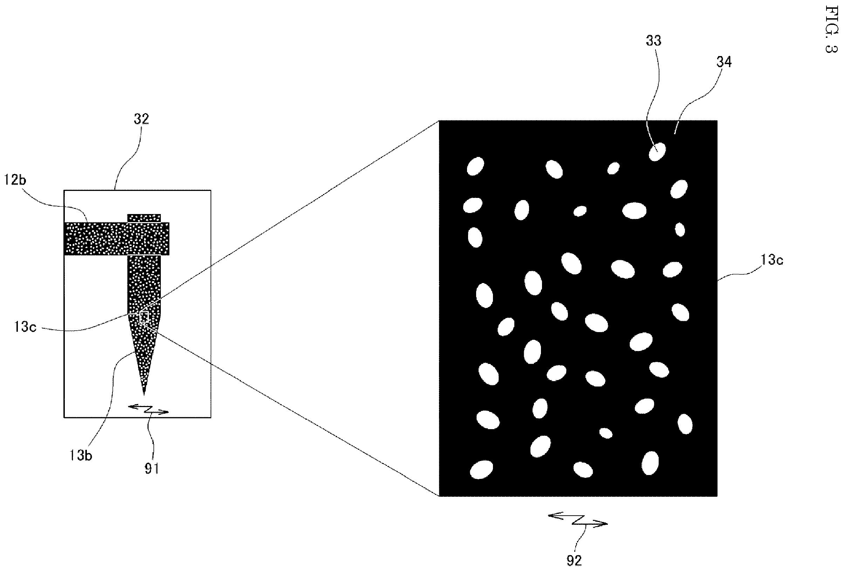

Because the interference pattern has a bright portion where rays of light intensify one another, and a dark portion where rays of light weaken one another, the imaging device 31 of the camera 30 acquires the interference pattern as a spotty image 13c including a large number of bright portions 33 and dark portions 34 appeared on the surface of an image 13b of the capillary 13, as illustrated in FIG. 3.

Therefore, when the camera 30 captures an image of the ultrasonic horn 12 and the capillary 13, the camera 30 acquires an image 12b of the ultrasonic horn 12 with a spotty pattern and the image 13b of the capillary 13 with a spotty pattern, as illustrated in a field of view 32 in FIG. 13. The images 12b and 13b are images including interference patterns.

The exposure time used in imaging in the camera 30 is longer than the vibration cycles of the ultrasonic vibrations of the ultrasonic horn 12 and the capillary 13. Therefore, if the ultrasonic horn 12 and the capillary 13 vibrate ultrasonically, the areas subjected to the peaks of the vibrations shake during the exposure, as indicated by arrows 91 and 92, in the image 12b of the ultrasonic horn 12 and the image 13b of the capillary 13 on the imaging device 31, the images 12b and 13b both having spotty patterns. By contrast, in the areas subjected to the nodes of the vibrations, even if the ultrasonic horn 12 and the capillary 13 vibrate ultrasonically, the image 12b and the image 13b on the imaging device 31 do not shake during the exposure.

In the area where the images 12b and 13b shake during the exposure, the luminous intensities of pixels 36 of the imaging device 31 are different from those in a still or non-vibrating condition where the ultrasonic horn 12 and the capillary 13 do not vibrate ultrasonically. As an example, in the area subjected to the peak of a vibration, the luminous intensities of the pixels 36 become greater than those when the area is not vibrating.

By contrast, when the images 12b and 13b do not shake during the exposure because the images are at vibration nodes, the images 12b and 13b are substantially same as the images 12a and 13b resultant of the ultrasonic horn 12 and the capillary 13 being in the still or the non-vibrating condition. Therefore, in the area at the nodes of the vibration where the images 12b and 13b do not shake during the exposure, the luminous intensities of the pixels 36 of the imaging device 31 remain substantially the same as those in the still or non-vibrating condition in which the ultrasonic horn 12 and the capillary 13 are not ultrasonically vibrating.

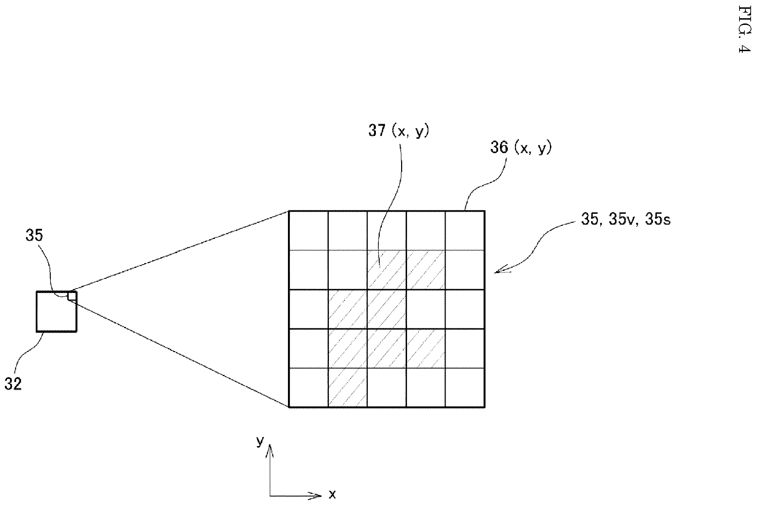

Therefore, as illustrated in FIG. 4, the processor 41 in the image processing apparatus 40 identifies a pixel 36 in which the luminous intensity has changed during the ultrasonic vibration from that during the still or non-vibrating condition, as a vibrating pixel 37. At this time, the luminous intensity is luminance detected at the pixel 36, and may be represented by, for example, a 256 grayscale ranging from 0 to 255.

The image processing apparatus 40 identifies the vibrating pixel 37 by performing the processing to be described below, on each pixel 36 of an image frame 35 that is an area to be applied with the image processing at once, in a two-dimensional image within the field of view 32. In the following description, coordinates (x, y) appended after a reference numeral indicate the coordinates (x, y) of the two-dimensional image frame 35, and, for example, a pixel 36 (x, y) indicates a pixel 36 at the coordinates (x, y).

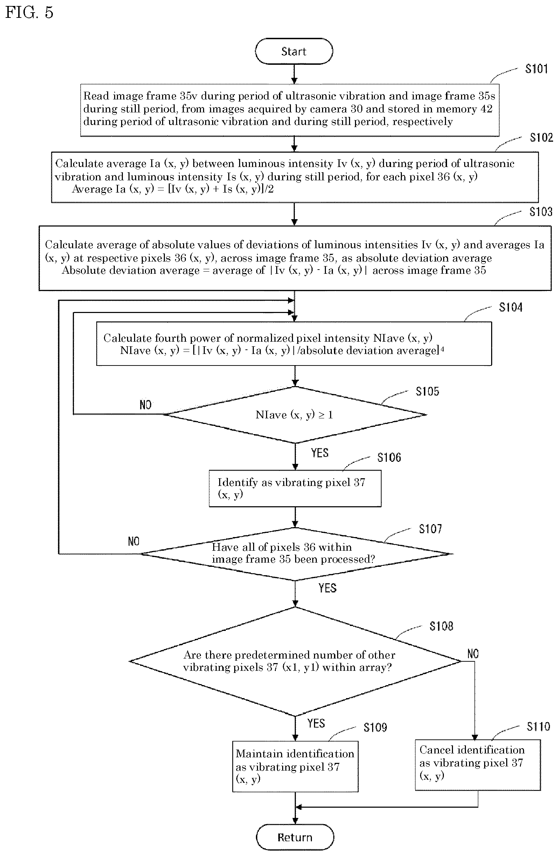

As illustrated in step S101 in FIG. 5, the processor 41 in the image processing apparatus 40 reads an image frame 35v during a period of ultrasonic vibration and an image frame 35s during a still period, from a two-dimensional image during the period of the ultrasonic vibration and from a two-dimensional image during a still or non-vibrating period, respectively, the two-dimensional images being acquired from the camera 30 and stored in the memory 42.

As illustrated in step S102 in FIG. 5, the processor 41 calculates an average Ia (x, y) of a luminous intensity Iv (x, y) during the period of ultrasonic vibration and a luminous intensity Is (x, y) during the still period, for each of the pixels 36 (x, y).

$$\text{Average Ia (x, y)} = [\text{Iv (x, y)} + \text{Is (x, y)}]/2$$

As indicated in step S103 in FIG. 5, the processor 41 calculates an average of the absolute values of deviations across the image frame 35 as an absolute deviation average, the deviations being those between the luminous intensities Iv (x, y) during the period of ultrasonic vibration and the averages Ia (x, y) at the respective pixels 36 (x, y).

Absolute deviation average = average of |Iv (x, y) - Ia (x, y)| across image frame 35

As illustrated in step S104 in FIG. 5, the processor 41 calculates the fourth power of a normalized pixel intensity NIave (x, y) using the following (Equation 1).

$$\text{NIave } (x, y) = [|\text{Iv } (x, y) - \text{Ia } (x, y)|/\text{absolute deviation average}]^4 \text{ ---- (Equation}$$

1)

As illustrated in step S105 in FIG. 5, if NIave (x, y) is equal to or more than 1, the processor 41 determines that the change in the luminous intensity at the pixel 36 (x, y) is significant, goes to step S106 in FIG. 5, identifies the pixel 36 (x, y) as the vibrating pixel 37 (x, y), and goes to step S107. In step S107, if it is determined that all of the pixels 36 (x, y) within the image frame 35 have not been processed yet, the processor 41 goes back to step S104, and performs the processing on the next pixel 36 (x, y). By contrast, if it is determined NO in step S105 in FIG. 5, the processor 41 goes back to step S104 and performs processing of the next pixel 36 (x, y). If the processor 41 has calculated NIave (x, y) in all of the pixels 36 (x, y) within the image frame 35, and identified the vibrating pixel 37 (x, y) within the image frame 35, YES is determined in step S107 in FIG. 5, and the process goes to step S108 in FIG. 5.

In step S108 in FIG. 5, the processor 41 checks whether there are a predetermined number of other vibrating pixels 37 (x1, y1) within a predetermined range around a vibrating pixel 37 (x, y). For example, it is possible to establish a square array consisting of 5 × 5 pixels 36 having its center at the vibrating pixel 37 (x, y) as the predetermined range, and to check whether there are seven or eight other vibrating pixels 37 (x1, y1) within this square array. If it is determined as YES in step S108 in FIG. 5, it is determined that the change in the luminous intensity at the pixel 36 (x, y) is caused by an ultrasonic vibration, and the process goes to step S109 in FIG. 5, and maintains the pixel 36 (x, y) as a pixel identified as the vibrating pixel 37 (x, y).

By contrast, if there are no seven or eight other vibrating pixels 37 (x1, y1) in the array, it is determined that the change in the luminous intensity at the pixel 36 (x, y) is not caused by a vibration, and the process goes to step S110 in FIG. 5, to cancel the identification of the pixel 36 (x, y) as the vibrating pixel 37 (x, y).

The processor 41 then finalizes the identifications of the vibrating pixels 37 (x, y). The processor 41 performs the above processing on each of the image frames 35, and finalizes the identifications of the vibrating pixels 37 (x, y) across all of the pixels 36 (x, y) of the imaging device 31.

As illustrated in FIG. 6, the processor 41 then visualizes and presents the vibrations on the two-dimensional surface of the ultrasonic horn 12 and the capillary 13 by outputting observation images 12e and 13e in which indications of the identified vibrating pixels 37 (x, y) are included in the images of the ultrasonic horn 12 and the capillary 13.

The observation images 12e and 13e may have various formats, and in FIG. 5, as an example, red points 52 are displayed in a manner superimposed over the parts corresponding to the vibrating pixels 37 in general images acquired by irradiating the ultrasonic horn 12 and the capillary 13 with incoherent light such as electric light. According to this display method, many red points 52 are displayed in the area at the peak of the vibration, and almost no red point is displayed in the part at the node of the vibration. In the example illustrated in FIG. 5, it can be seen that the ultrasonic horn 12, a middle part where the diameter of the capillary 13 changes, and the tip portion of the capillary 13 in which many red points 52 are displayed have peaks of the vibrations, and the other portions correspond to the nodes of vibration.

As described above, because the vibration detection system 100 according to the embodiment processes the two-dimensional images of the ultrasonic horn 12 and the capillary 13 and displays the processed images as the two-dimensional observation images 12e and 13e, it is possible to detect vibrations on the two-dimensional surface of the ultrasonic horn 12 and the capillary 13 in real time.

In the above description, the vibration detection system 100 has been described to detect vibrations of the ultrasonic horn 12 and the capillary 13 of the wire bonding apparatus 10, but may also be applied to the detection of vibrations of other parts of the wire bonding apparatus 10.

For example, when the wire bonding apparatus 10 illustrated in FIG. 1 performs bonding, vibrations of the semiconductor device 17 may be detected by irradiating the semiconductor device 17 with the parallel laser light 21. When the vibrations of the semiconductor device 17 are large, it is possible to determine that the vibration energy from the capillary 13 is consumed in the vibrations other than that for bonding, and therefore, bonding is not being performed well. Similarly, it is also possible to detect whether the vibrations of the substrate 18 are large, and, if the vibrations of the substrate 18 are large, to determine that the vibration energy from the capillary 13 is consumed in the vibrations other than bonding, and therefore, bonding is not being performed well.

In addition, the vibration detection system 100 may be applied to detections of vibrations of units included in a device other than the wire bonding apparatus 10, e.g., another semiconductor manufacturing device such as a die bonding device.

In the above description, the laser light source 20 is described to irradiate the observation target with the parallel laser light 21 having a single wavelength, but the present invention is not limited thereto, and it is possible to use a small range of the wavelengths, or to irradiate the observation target with laser light that is not parallel light. In addition, the laser light may have some unevenness in intensity. Furthermore, in the above description, the image of the interference pattern has been described as a spotty pattern including the large number of bright portions 33 and dark portions 34, but is not limited thereto, and may be another pattern such as a stripe pattern.

Furthermore, when the direction in which the observation target vibrates is not one direction, vibrations in a plurality of directions may be detected by preparing a plurality of laser light sources 20 and cameras 30, irradiating the observation target with rays of laser light from a plurality of respective directions, and capturing images with the respective cameras 30 at the respective directions.

Reference Signs List

| 10 | wire bonding apparatus |
|---|---|
| 11 | bonding arm |
| 12 | ultrasonic horn |
| 12a, 13b, 13c | images |
| 12e, 13e | observation images |
| 13 | capillary |
| 13a | surface |
| 14 | ultrasonic transducer |
| 15 | wire |
| 16 | bonding stage |
| 17 | semiconductor device |
| 18 | substrate |
| 19 | loop wire |
| 20 | laser light source |
| 21 | parallel laser light |
| 22 | reflected laser light |
| 30 | camera |
| 31 | imaging device |
| 32 | field of view |
| 33 | bright portion |
| 34 | dark portion |
| 35, 35v, 35s | image frames |
| 36 | pixel |
| 37 | vibrating pixel |
| 40 | image processing apparatus |
| 41 | processor |
| 42 | memory |
| 50 | monitor |
| 52 | red point |
| 100 | vibration detection system |

Claims

1. A vibration detection system that detects a vibration of an observation target having a non-mirror surface, the vibration detection system comprising:

a laser light source that irradiates the observation target with laser light;
a camera that includes an imaging device that captures and acquires an image of the observation target irradiated with the laser light; and
an image processing apparatus that processes the image captured by the camera and that displays a vibrating potion.

2. The vibration detection system according to claim 1, wherein

the camera uses an exposure time longer than a vibration cycle of the observation target at time of imaging and acquires the image as an image including an interference pattern that is formed by interference of reflections of the laser light from a surface of the observation target, and

the image processing apparatus identifies a vibrating pixel based on a deviation between an image including an interference pattern of the observation target during a non-vibrating period and an image including an interference pattern of the observation target during a vibrating period, the images being those acquired by the camera, and outputs an observation image that is an image of the observation target including an indication corresponding to the identified vibrating pixel.

3. The vibration detection system according to claim 2, wherein
when there are a predetermined number of other vibrating pixels within a predetermined range around the identified vibrating pixel, the image processing apparatus maintains the pixel as a pixel identified as the vibrating pixel, and when there are no predetermined number of vibrating pixels within the predetermined range, the image processing apparatus cancels identification of the pixel as the vibrating pixel.

4. The vibration detection system according to claim 2 or 3, wherein
the laser light source irradiates the observation target with parallel laser light having a single wavelength.

FIG. 1

FIG. 2

FIG. 3

FIG. 4

FIG. 5

Start

S101
Read image frame 35v during period of ultrasonic vibration and image frame 35s during still period, from images acquired by camera 30 and stored in memory 42 during period of ultrasonic vibration and during still period, respectively

S102
Calculate average Ia (x, y) between luminous intensity Iv (x, y) during period of ultrasonic vibration and luminous intensity Is (x, y) during still period, for each pixel 36 (x, y)
    Average Ia (x, y) = [Iv (x, y) + Is (x, y)]/2

S103
Calculate average of absolute values of deviations of luminous intensities Iv (x, y) and averages Ia (x, y) at respective pixels 36 (x, y), across image frame 35, as absolute deviation average
    Absolute deviation average = average of | Iv (x, y) - Ia (x, y) | across image frame 35

S104
Calculate fourth power of normalized pixel intensity NIave (x, y)
    NIave (x, y) = [| Iv (x, y) - Ia (x, y) |/absolute deviation average]⁴

S105
NIave (x, y) ≥ 1
NO
YES

S106
Identify as vibrating pixel 37 (x, y)

S107
Have all of pixels 36 within image frame 35 been processed?
NO
YES

S108
Are there predetermined number of other vibrating pixels 37 (x1, y1) within array?
NO
YES

S109
Maintain identification as vibrating pixel 37 (x, y)

S110
Cancel identification as vibrating pixel 37 (x, y)

Return

FIG. 6

**INTERNATIONAL SEARCH REPORT**

| International application No. |
|---|
| PCT/JP2020/033353 |

**A. CLASSIFICATION OF SUBJECT MATTER**
G01H 9/00(2006.01)i
FI: G01H9/00 C

According to International Patent Classification (IPC) or to both national classification and IPC

**B. FIELDS SEARCHED**

Minimum documentation searched (classification system followed by classification symbols)
G01H9/00

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 10-221159 A (TOSHIBA CORP.) 21 August 1998 (1998-08-21) paragraphs [0016]-[0043] | 1<br>2-4 |
| A | JP 2017-003397 A (NIIGATA UNIVERSITY) 05 January 2017 (2017-01-05) entire text, all drawings | 1-4 |
| A | CN 105258783 A (HANGZHOU DIANZI UNIVERSITY) 20 January 2016 (2016-01-20) entire text, all drawings | 1-4 |
| A | JP 2012-516432 A (SIEMENS AG) 19 July 2012 (2012-07-19) entire text, all drawings | 1-4 |
| A | JP 2008-286797 A (POLYTEC GMBH) 27 November 2008 (2008-11-27) entire text, all drawings | 1-4 |
| A | JP 8-068673 A (TOSHIBA CORP.) 12 March 1996 (1996-03-12) entire text, all drawings | 1-4 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 November 2020 (02.11.2020) | 17 November 2020 (17.11.2020) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**
Information on patent family members

International application No.

PCT/JP2020/033353

| Patent Documents referred in the Report | Publication Date | Patent Family | Publication Date |
|---|---|---|---|
| JP 10-221159 A | 21 Aug. 1998 | (Family: none) | |
| JP 2017-003397 A | 05 Jan. 2017 | (Family: none) | |
| CN 105258783 A | 20 Jan. 2016 | (Family: none) | |
| JP 2012-516432 A | 19 Jul. 2012 | US 2012/0019654 A1 entire text, all drawings WO 2010/086044 A1 CN 102301212 A | |
| JP 2008-286797 A | 27 Nov. 2008 | US 2008/0291466 A1 entire text, all drawings DE 102007023826 A1 FR 2916534 A1 | |
| JP 8-068673 A | 12 Mar. 1996 | US 5822450 A entire text, all drawings | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013125875 A